# EUROPÄISCHE PATENTSCHRIFT

(11) **EP 0 519 088 B1**
(45) Veröffentlichungstag und Bekanntmachung des Hinweises auf die Patenterteilung: **25.01.1995**
(21) Anmeldenummer: 91109499.3
(22) Anmeldetag: 10.06.1991
(51) Int. Cl.: H04R 25/00, H03G 11/00

(54) **Verfahren und Schaltungsanordung zum Begrenzen eines Ausgangssignals**
Procedure and circuit for limiting an output signal
Méthode et circuit pour limitation d'un signal de sortie

(43) Veröffentlichungstag der Anmeldung: 23.12.1992
(73) Patentinhaber: Siemens Audiologische Technik GmbH, 91058 Erlangen (DE)
(72) Erfinder: Martin, Raimund, W-8520 Erlangen (DE); Wolf, Herbert, W-8520 Erlangen (DE)
(74) Vertreter: Fuchs, Franz-Josef, Dr.-Ing.

(56) Entgegenhaltungen:
- NL-A- 8 601 169
- IEEE JOURNAL OF SOLID-STATE CIRCUITS. Bd. 24, Nr. 2, April 1989, NEWYORK US Seiten 301 - 312; F. CALLIAS ET AL.: 'A Set of Four IC's in CMOSTechnology for a Programmable Hearing Aid'
- IEEE TRANSACTIONS ON CONSUMER ELECTRONICS. Bd. CE-24, Nr. 3, August 1978, New York US, Seiten 308 - 316, J.A. DUTRA: "Digital Amplifiers for Anolog Power"

## Beschreibung

Die vorliegende Erfindung bezieht sich auf ein Verfahren zum Begrenzen eines Ausgangssignales, das aus einem pulsdauermodulierten Signal über ein demodulierend wirkendes Mittel entnehmbar ist. Die Erfindung bezieht sich weiterhin auf eine Schaltungsanordnung, insbesondere zur Durchführung des Verfahrens, wenigstens umfassend ein demodulierend wirkendes Mittel zur Abgabe eines begrenzten Ausgangssignales und eine erste Vergleichsstufe, die eingangsseitig mit einem Dreieckspannungsgenerator und mit einem ein Basissignal abgebenden Bauteil zur Erzeugung eines Steuersignales verbunden ist.

Vor allem im Zusammenhang mit batteriebetriebenen Hörgeräten wird aus Gründen der Stromersparnis eine Schaltungsanordnung der eingangs genannten Art verwandt, vergleiche z.B. die DE-PS 36 16 752. In derartigen Anwendungen erfolgt die Demodulation des pulsdauermodulierten Steuersignales für die im Schaltbetrieb arbeitende Endstufe (Klasse-D-Verstärker) aufgrund der Tiefpaßwirkung des ohnehin erforderlichen Hörers des Hörgerätes. Des weiteren ist es bekannt, die Amplitude von Ausgangssignalen (Nutzsignalen) zu begrenzen, was z.B. in Hörgeräten mittels sogenannten Peak-Clipping-Schaltungen in der Endstufe durchgeführt wird. Bei einem pulsdauermodulierten Signal ist die Amplitude des Ausgangssignales (Nutzsignales) aber in der Dauer (Breite) der Einzelimpulse des die Endstufe schaltenden Steuersignales kodiert. Daher ist mit herkömmlichen Verfahren oder Schaltungsanordnungen die Amplitude des in der Pulsdauer kodierten Nutzsignales (Basissignal) nicht in der Endstufe begrenzbar. Man hat daher schon die Leistung der Endstufe über eine dem Hörer zugeführte und verminderte Betriebsspannung (bzw. Betriebsstrom) begrenzt. Das führt aber zu einer unerwünschten Verstärkungs- und Leistungsverminderung des demodulierten Ausgangssignales. Um diesen Nachteil zu vermeiden, hat man schon das Nutzsignal in einer Vorstufe begrenzt und mit diesem vorab begrenzten Nutzsignal eine Pulsdauermodulation erzeugt. Dadurch entsteht aber eine unerwünschte spektrale Verbreiterung des Nutzsignals schon vor dem Pulsdauermodulator, was zu unerwünscht hohen Rückfaltungsprodukten (hohe Verzerrungen) im Ausgangssignal führt.

Im I.E.E.E. Journal of Solid-State Circuits, Bd. 24, No. 2, April 1989, New York, US, Seiten 301-312 (A Set of Four IC's in CMOS Technology for a Programmable Hearing Aid) ist ein Class-D Verstärker für ein programmierbares Hörgerät beschrieben, wobei eine Verstärkerendstufe mit 32 kHz Sägezahngenerator vorgesehen ist. Der das Class-D Verstärkerprinzip beschreibende Aufsatz beschäftigt sich jedoch nicht mit dem Problem der Begrenzung eines pulsdauermodulierten Ausgangssignales.

Der Erfindung liegt die Aufgabe zugrunde, ein Verfahren und eine Schaltungsanordnung der eingangs genannten Art anzugeben, womit ohne Verstärkungsverminderung bei nur geringen Verzerrungen eine Begrenzung des entnehmbaren Ausgangssignales (Nutzsignales) erreicht wird.

Diese Aufgabe wird durch ein Verfahren gemäß Anspruch 1 und durch eine Vorrichtung gemäß Anspruch 6 gelöst.

Gemäß der Erfindung werden aus dem für die Pulsdauermodulation ohnehin erforderlichen Summensignal (Basissignal plus Abtastsignal) zusätzliche Impulse für die Begrenzung erzeugt. Diese zusätzlichen Impulse entstehen nur dann, wenn eine vorzugsweise variable (einstellbare) Schwellenspannung von dem Summensignal überschritten wird. Die zusätzlichen Impulse werden in das pulsdauermodulierte Steuersignal eingefügt (zusätzliche Modulation). Die zusätzlichen Impulse im Steuersignal bewirken erst nach einer Verstärkung und bei einer Demodulation des Steuersignales eine Begrenzung der Amplitude des demodulierten Ausgangssignales (Nutzsignales). Dadurch wird ohne Verstärkungsverminderung (Leistungsverminderung), z.B. in einer geschalteten Endstufe, bei nur geringen Verzerrungen eine Begrenzung des verstärkten Ausgangssignales erreicht.

Weitere Vorteile und Einzelheiten der Erfindung ergeben sich aus der nachfolgenden Beschreibung von Ausführungsbeispielen anhand der Zeichnungen und in Verbindung mit den Ansprüchen.

Es zeigen:
Figur 1 eine Darstellung von Signalen, von denen die Erfindung ausgeht;
Figur 2 eine Darstellung von Signalen und Impulsen nach dem erfindungsgemäßen Verfahren;
Figur 3 eine erfindungsgemäße Schaltungsanordnung als Blockschaltbild;
Figur 4 eine weitere erfindungsgemäße Schaltungsanordnung als Blockschaltbild und
Figur 5 eine erfindungsgemäße Schaltungsanordnung gemäß Figur 4 in Verbindung mit einer Hörgeräteschaltung.

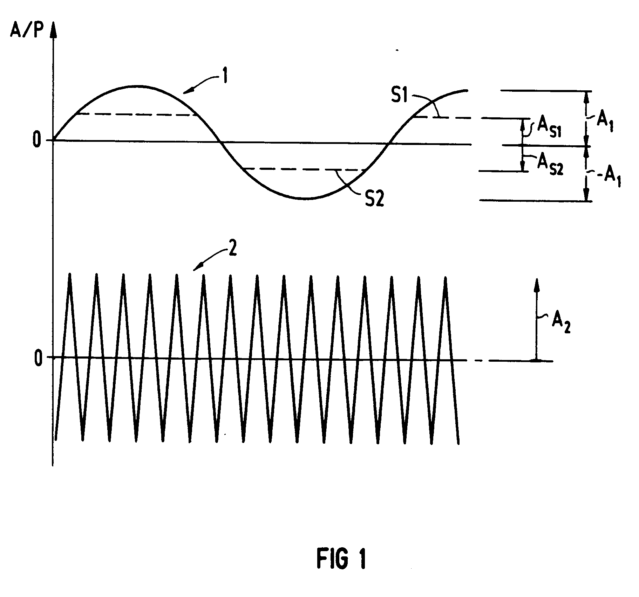

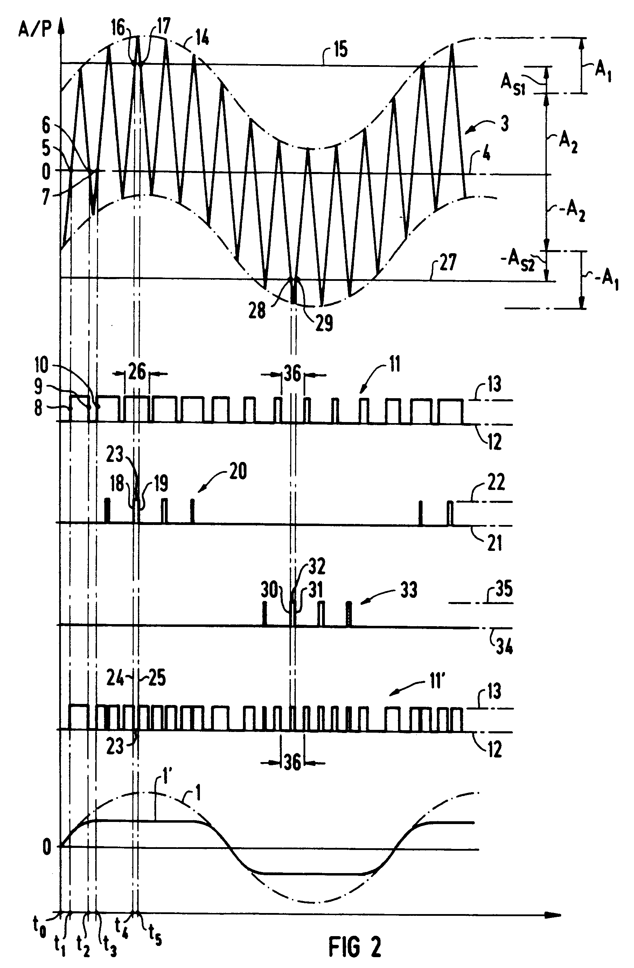

In Figur 1 und in Figur 2 sind beginnend in einem Zeitpunkt t₀ (Figur 2) an der Ordinate verschiedene Signal- und Impulsformen mit ihren Amplituden/Pegeln (A/P) über der Abszisse in Abhängigkeit von der Zeit (t) dargestellt und einander zugeordnet.

Die obere Kurve in Figur 1 zeigt ein Basissignal 1 (Nutzsignal) mit einer Amplitude A₁ (rechter Pfeil). Darunter ist ein dreieckförmiges Abtastsignal 2 mit einer Amplitude A₂ (rechter Pfeil) dargestellt. Das Abtastsignal 2 ist gegenüber dem Basissignal 1 höherfrequent mindestens gemäß dem bekannten Abtasttheorem gewählt und bildet durch Zusammenwirken mit dem Basissignal 1 ein Summensignal 3, das in Figur 2, oben, dargestellt ist. Dem Summensignal 3 ist ein Bezugspotential 4 (Nullinie) zugeordnet. Das Summensignal 3 durchläuft im ständigen Wechsel (frequenzabhängig) das Bezugspotential 4 (frequenzlos). Folglich stimmen zu bestimmten Zeitpunkten t₁ bis bis t₃ (auf der Abszisse) das Bezugspotential 4 und die Wechselspannung des Summensignales 3, z.B. in bestimmten Punkten 5, 6 und 7, überein. Aus jeder derartigen Übereinstimmung, z.B. 5, 6 und 7, wird eine Impulsflanke, z.B. 8, 9 und 10, eines Steuersignales 11 erzeugt, das zwischen einem niedrigen Pegel 12 und einem hohen Pegel 13 wechselt. Vorzugsweise wird dabei aus jeder Ubereinstimmung, z.B. 5 und 6, die aus einer ansteigenden Amplitude im Summensignal 3 entsteht, eine ansteigende Impulsflanke, z.B. 8 und 10, im Steuersignal 11 erzeugt. Dementsprechend wird aus jeder Übereinstimmung, z.B. 6, die aus einer abfallenden Amplitude im Summensignal 3 entsteht, eine abfallende Impulsflanke, z.B. 9, im Steuersignal erzeugt. Der Abstand zwischen den einzelnen Impulsflanken, z.B. 8 bis 10 bzw. den Zeitpunkten t₁ bis t₃, ist von der Amplitude des Basissignales 1 abhängig, die einer im Summensignal 3 strichliert dargestellten Hüllkurve 14 entspricht.

Das Basissignal 1 verschiebt entsprechend einem Momentanwert der Amplitude A₁ das Dreiecksignal 2 in dem Summensignal 3 gegenüber dem Bezugspotential 4. Dadurch variieren die zeitlichen Abstände, z.B. zwischen den Zeitpunkten t₁ bis t₃, in denen das Bezugspotential 4 mit einem Momentanwert des Dreiecksignales 2 im Summensignal 3 übereinstimmt. Folglich kann das Basissignal 1 als ein Modulationssignal betrachtet werden, dessen Modulation in der jeweiligen Impulsdauer des Steuersignales 11 enthalten ist. Das Steuersignal 11 ist folglich ein pulsdauermoduliertes Signal. Dabei entspricht eine Impulsperiode im dem Steuersignal 11 genau einer Periode im Dreiecksignal 2, also z.B. dem Zeitraum zwischen den Zeitpunkten t₁ und t₃.

In dem Basissignal 1 (obere Kurve in Figur 1) sind strichlierte Linien S1 und S2 eingezeichnet, die die maximal zulässige Amplitude eines noch zu begrenzenden und demodulierten Ausgangssignales darstellen. Die maximal zulässigen Amplituden sind als Pfeile A_{S1} und -A_{S2} am rechten Rand der Figur 1 dargestellt. Für die erfindungsgemäße Begrenzung ist vorgesehen, das Summensignal 3 (obere Kurve in Figur 2) mit wenigstens einem ersten Schwellenpotential 15 auf Übereinstimmung zu vergleichen. Dieses erste Schwellenpotential 15 ist so gewählt, daß es größer als die Amplitude A₂ und kleiner als die Summe der Amplitude A₁ plus der Amplitude A₂ ist. In der Darstellung rechts neben dem Summensignal 3 in Figur 2 ergibt sich das Schwellenpotential 15 aus der Addition der Amplitude A₂ und der Amplitude A_{S1}. Eine Übereinstimmung tritt z.B. an einem Punkt 16 und an einem Punkt 17 auf. Aus jeder Übereinstimmung, z.B. 16 und 17, mit dem ersten Schwellenpotential 15 wird eine Impulsflanke, z.B. 18 bzw. 19, eines ersten Begrenzersignales 20 erzeugt, das zwischen einem niedrigen Pegel 21 und einem hohen Pegel 22 wechselt. Die Impulsflanke 18 entsteht in einem Zeitpunkt t₄ und die Impulsflanke 19 entsteht in einem Zeitpunkt t₅. Die Dauer eines Impulses wird folglich aus dem zeitlichen Abstand, z.B. zwischen den Zeitpunkten t₄ und t₅, bzw. zwischen zwei Übereinstimmungen, z.B. 16 und 17, mit dem ersten Schwellenpotential 15 und mit dem jeweiligen Momentanwert des Summensignales 3 gebildet. Je weiter die Amplitude des Summensignales 3 das erste Schwellenpotential 15 übertrifft, desto größer ist die Dauer eines Impulses in dem ersten Begrenzersignal 20. Ein von den Impulsflanken 18 und 19 begrenzter Impuls im ersten Begrenzersignal 20 hat eine mit dem Bezugszeichen 23 markierte Impulsdauer.

Nach dem erfindungsgemäßen Verfahren ist vorgesehen, das Steuersignal 11 und das erste Begrenzersignal 20 miteinander zu mischen. Das Ergebnis einer derartigen Mischung ist in Figur 2 in einem zweiten Steuersignal 11′ dargestellt und wird beispielhaft an dem die Impulsdauer 23 aufweisenden Impuls erläutert. Die Impulsflanken 18 und 19 fallen mit Hilfslinien 24 und 25 zusammen. In dem aus dem Steuersignal 11 und dem Begrenzersignal 20 gemischten zweiten Steuersignal 11′ ist gemäß Figur 2 dargestellt, daß ein ursprünglicher Impuls im Steuersignal 11 mit der Dauer 26 während der Dauer 23 eines Impulses im ersten Begrenzersignal 20 unterbrochen wird. Folglich wechselt während der Dauer eines Impulses im ersten Begrenzersignal 20 der jeweils vorhandene Pegel 12 oder 13 (schaltungsabhängig) in dem zweiten Steuersignal 11′. In dem dargestellten Beispiel wechselt der vor der Hilfslinie 24 hohe Pegel 13 während der Dauer 23 auf den niedrigen Pegel 12 und springt nach dem Ende des aus dem Steuersignal 20 eingefügten Impulses mit der Dauer 23, also nach der Hilfslinie 25, wieder auf den ursprünglich hohen Pegel 13 zurück. Dieses erfindungsgemäße Verfahren bewirkt, daß bei einer Demodulation des erfindungsgemäß beeinflußten zweiten Steuersignales 11′ - z.B. durch Integration der zu demodulierenden Spannung, die z.B. aus der ursprünglichen Impulsdauer 26 erzeugt würde - die demodulierte Spannung durch die Unterbrechung während der Impulsdauer 23 geringer ausfällt. Im Ergebnis ist das demodulierte Ausgangssignal (das ursprüngliche Basissignal 1) in der Amplitude begrenzt, wie es in der unteren Kurve anhand des Basissignales 1′ (demoduliertes Signal) in der ersten (positiven) Halbwelle dargestellt ist.

Aus den vorstehenden Erläuterungen geht hervor, daß mit dem ersten Schwellenpotential 15 eine erste Halbwelle, z.B. die positive Halbwelle, begrenzbar ist, was für etliche (einphasige) Anwendungen des Verfahrens genügen kann. Wenn es aber erforderlich ist, beide Halbwellen zu verarbeiten und zu begrenzen, ist in Ausbildung der Erfindung ein zweites Schwellenpotential 27 vorgesehen. Das zweite Schwellenpotential 27 wirkt gegenüber dem ersten Schwellenpotential 15 gegenpolig, was anhand der Pfeile rechts neben dem Summensignal 3 zeichnerisch dargestellt ist. Im übrigen gelten die Ausführungen bezüglich des ersten Schwellensignales 15 bei dem zweiten Schwellensignal 27 entsprechend.

In der Figur 2 ist beispielhaft dargestellt, daß das zweite Schwellenpotential 27 an Punkten 28 und 29 mit je einem Momentanwert des Summensignales 3 übereinstimmt. Aus diesen Ubereinstimmungen 28 und 29 werden Impulsflanken 30 und 31 eines Impulses mit der Dauer 32 in einem zweiten Begrenzersignal 33 gebildet. Das zweite Begrenzersignal 33 wechselt zwischen einem niedrigen Pegel 34 und einem hohen Pegel 35. Eine Impulspause 36 in dem Steuersignal 11 bzw. in dem zweiten Steuersignal 11′ wird durch den Impuls mit der Dauer 32 unterbrochen, wie es im zweiten Steuersignal 11′ dargestellt ist. Folglich wechselt während der Unterbrechung der ursprünglich niedrige Pegel 12 im zweiten Steuersignal 11′ während der Dauer 32 auf einen hohen Pegel 13, um nach dem Ende des Impulses - entspricht der Impulsflanke 31 aus dem zweiten Begrenzersignal 33 - wieder auf den ursprünglich niedrigen Pegel 12 der Impulspause 36 im zweiten Steuersignal 11′ zu wechseln. Im Ergebnis wird folglich auch die zweite (negative) Halbwelle des demodulierten Basissignales 1′ begrenzt, wie es in der unteren Kurve der Figur 2 dargestellt ist.

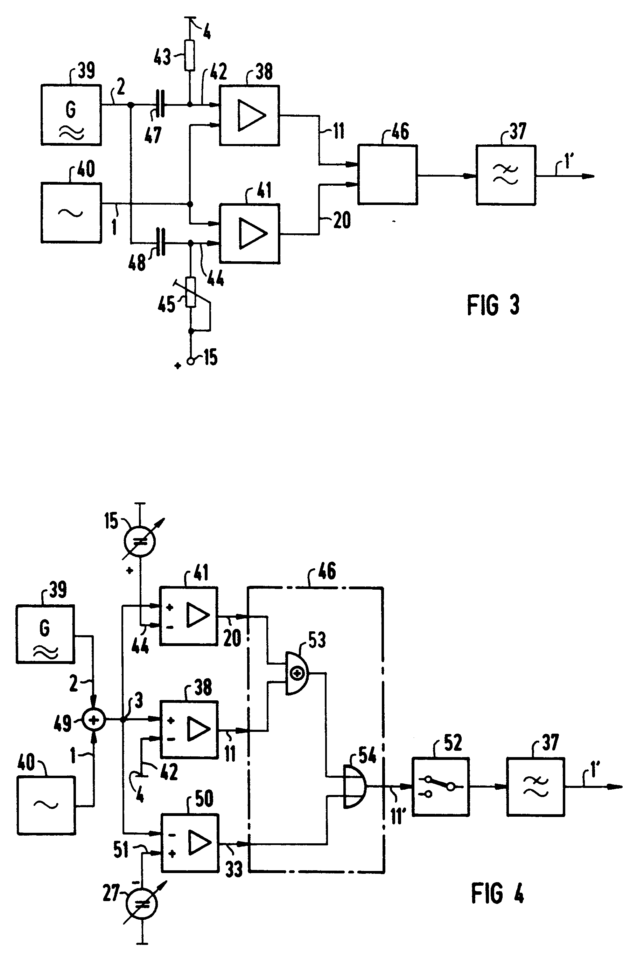

In Figur 3 ist eine Schaltungsanordnung dargestellt, die insbesondere zur Durchführung des beschriebenen Verfahrens geeignet ist. Diese Schaltungsanordnung gibt ausgangsseitig das in Figur 2 unten dargestellte begrenzte Ausgangssignal 1′ einphasig aus. Als demodulierend wirkendes Mittel ist ein Tiefpaß 37 vorgesehen. Die Schaltungsanordnung weist des weiteren eine erste Vergleichsstufe 38 auf, die eingangsseitig mit einem Dreieckspannungsgenerator 39 und mit einem das Basissignal 1 abgebenden Bauteil 40 zur Erzeugung eines Steuersignales 11 verbunden ist. Ein Eingang 42 der ersten Vergleichsstufe 38 ist mit dem Basispotential 4, z.B. Massepotential, über einen Widerstand 43 verbunden.

Erfindungsgemäß ist eine zweite Vergleichsstufe 41 vorgesehen, die eingangsseitig ebenfalls mit dem Dreieckspannungsgenerator 39 und mit dem das Basissignal 1 abgebenden Bauteil 40 verbunden ist. Ein Eingang 44 der zweiten Vergleichsstufe 41 ist ist mit dem ersten Schwellenpotential 15, z.B. über einen einstellbaren Widerstand 45, verbunden. Die beiden Vergleichsstufen 38 und 41 sind ausgangsseitig über eine Mischschaltung 46 mit dem demodulierend wirkenden Mittel 37 verbunden.

In diesem Ausführungsbeispiel ist der Dreieckspannungsgenerator 39 zur Potentialtrennung über einen Kondensator 47 mit der Vergleichsstufe 38 und über einen Kondensator 48 mit der Vergleichsstufe 41 gekoppelt. Andere Kopplungsarten können z.B. in Abhängigkeit vom jeweiligen Anwendungsfall frei gewählt werden. Bei der Schaltungsanordnung gemäß Figur 3 entsteht das in Figur 2 dargestellte Summensignal 3 nur innerhalb der Vergleichsschaltung 38 bzw. 41, die z.B. als Komparatoren ausgebildet sein können. Folglich ist das Summensignal 3 an den Anschlüssen der Vergleichsschaltung 38 bzw. 41 nicht meßbar (nicht ausgebildet). Dagegen sind die Signale 1, 2, 11 und 20 an den entsprechend markierten Leitungen meßbar.

In der Schaltungsanordnung gemäß Figur 4 wird mit Hilfe eines Summiergliedes 49 bereits vor den Vergleichsschaltungen 38 und 41 das Summensignal 3 erzeugt. Abweichend von der Schaltungsanordnung gemäß Figur 3 ist in Figur 4 erfindungsgemäß eine dritte Vergleichsstufe 50 vorgesehen, die z.B. als Komparator ausgebildet ist und eingangsseitig über das Summierglied 49 ebenfalls mit dem Dreieckspannungsgenerator 39 und mit dem das Basissignal 1 abgebenden Bauteil 40 verbunden ist. Ein Eingang 51 der dritten Vergleichsstufe 50 ist mit dem gegenüber dem ersten Schwellenpotential 15 gegenpolig wirkenden zweiten Schwellenpotential 27 verbunden. Die Schwellenpotentiale 15 und 27 sind in Figur 4 als einstellbare Gleichspannungsquelle dargestellt. Der Eingang 42 an der ersten Vergleichsstufe 38 ist mit dem Bezugspotential 4 (Masse) verbunden und der Eingang 44 an der zweiten Vergleichsschaltung 41 ist mit dem ersten Schwellenpotential 15 verbunden. Die dritte Vergleichsstufe 50 ist ausgangsseitig ebenso wie die übrigen Vergleichsstufen 38 und 41 mit der Mischschaltung 46 und über eine Schaltstufe 52 mit dem Tiefpaß 37 verbunden. Der demodulierend wirkende Tiefpaß 37 gibt das doppelphasig begrenzte Ausgangssignal 1′ gemäß der Darstellung in Figur 2 ab.

Die Mischschaltung 46 ist mehrstufig ausgebildet. In einer ersten Mischstufe 53, die als EXOR-Glied (= Exklusiv-ODER-Schaltung) ausgebildet sein kann, werden die aus der ersten und zweiten Vergleichsstufe 38 und 41 entnehmbaren Signale 11 und 20 (vgl. Figur 2) gemischt. In einer zweiten Mischstufe 54, die z.B. als ODER-Schaltung ausgebildet sein kann, werden ein aus der ersten Mischstufe 53 entnehmbares Signal, also die Summe der Signale 11 und 20, und das aus der dritten Vergleichsstufe 50 entnehmbare zweite Begrenzersignal 33 gemischt. An der Mischschaltung 46 steht ausgangsseitig folglich ein Ausgangssignal zur Verfügung, das dem zweiten Steuersignal 11′ gemäß Figur 2 entspricht. Mit diesem zweiten Steuersignal 11′ kann z.B. eine Schaltstufe 52 angesteuert werden, z.B. um das zweite Steuersignal 11′ zu verstärken, bevor das darin enthaltene Basissignal (Modulationssignal) nach Demodulation als nunmehr verstärktes, aber in der Amplitude begrenztes Ausgangssignal 1′ zur Verfügung steht.

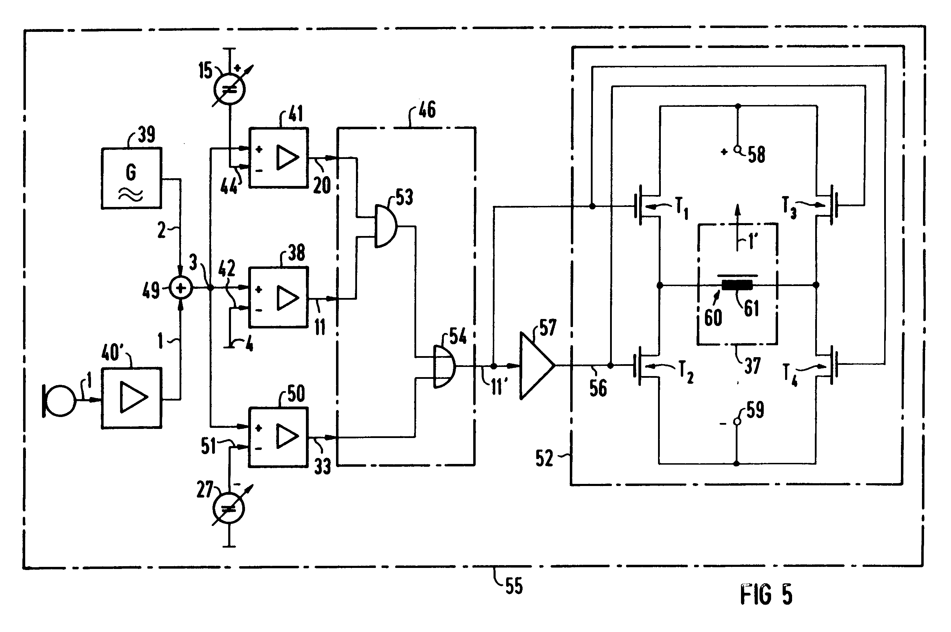

In Figur 5 ist ein Hörgerät 55 dargestellt, in welchem die Schaltungsanordnung gemäß Figur 4 verwendet ist. Das in Figur 4 dargestellte Bauteil 40 ist in Figur 5 als Verstärker 40′ ausgebildet, dem von einem Mikrofon 56 aufgenommene Hörschallsignale als Basissignal 1 zugeführt werden. Das dreieckförmige Abtastsignal 2 wird aus einem in dem Hörgerät 55 mit dem Ultraschallgenerator 39 erzeugten Ultraschallsignal gebildet. Das am Ausgang der Mischschaltung 46 entnehmbare zweite Steuersignal 11′ gemäß Figur 2 wird einer im Gegentakt betriebenen und als Schaltverstärker (Klasse-D-Verstärker) ausgebildeten Endstufe 52 zugeführt. Um den Gegentaktbetrieb zu ermöglichen, wird ein Gegentaktzweig 56 über einen Inverter 57 angesteuert, wodurch ein zu dem zweiten Steuersignal 11′ komplementäres Steuersignal entsteht.

Der Schaltverstärker 52 weist vier im Schaltbetrieb arbeitende MOS-FET-Transistoren T₁ bis T₄ auf. Die Transistoren T₁ und T₂ sowie die Transistoren T₃ und T₄ sind jeweils komplementär zueinander ausgebildet. Die Endstufe 52 wird über Anschlüsse 58 und 59 mit Betriebsspannung versorgt. Durch den Schaltbetrieb sind entweder die Transistoren T₁ und T₄ oder T₃ und T₂ gleichzeitig leitend. Der Zeitraum, innerhalb welchem diese Transistoren leitend sind, wird von der jeweiligen Impulsdauer eines jeden Impulses in dem zweiten Steuersignal 11′ gesteuert. Bei einem Wechsel des Pegels in dem Steuersignal 11 wechseln folglich auch die leitend geschalteten Transistoren in den nicht leitenden Zustand und die bisher nicht leitenden Transistoren werden sodann leitend. Im Ergebnis wird folglich das demodulierend wirkende Mittel 37 in der Endstufe 52 entsprechend der Impulse im zweiten Steuersignal 11′ zwischen den Anschlüssen 58 und 59 umgeschaltet.

Das demodulierend wirkende Mittel 37 ist in dem Ausführungsbeispiel gemäß Figur 5 ein Hörer 60 des Hörgerätes 55. Der Hörer 60 enthält eine Spule 61 (Induktivität), die aufgrund ihres Tiefpaßverhaltens integrierend (speichernd) wirkt. Die höherfrequenten Ultraschallanteile des zweiten Steuersignales 11′ werden folglich von der Spule 61 nicht durchgelassen. Aus dem Hörer 60 ist nur ein in der Amplitude begrenztes Hörschallsignal als Ausgangssignal gemäß der Kurve 1′ in Figur 2 entnehmbar.

Die Begrenzung entsteht durch die Unterbrechung eines beispielsweise ursprünglich langen Impulses mit der Dauer 26 durch einen kurzen Impuls mit der Dauer 23 bzw. durch die Unterbrechung einer langen Pause mit der Dauer 36 durch einen kurzen Impuls mit der Dauer 32, vergleiche dazu die Signale 11, 21, 33 und 11′ in Figur 2. Durch die zusätzlich eingefügten Begrenzungsimpulse kann sich der Strom bzw. die Spannung an der Spule 61 (Figur 5) nicht zu einer Höhe gemäß der Kurve 1 in Figur 1 ausbilden. Für die Einfügung der Begrenzungsimpulse in das zweite Steuersignal 11′ (Figur 2) ist es daher wesentlich, daß die Einfügung derart geschieht, daß ein vorhandener Zustand (hoher Pegel oder niedriger Pegel) durch den jeweils eingefügten Begrenzungsimpuls unterbrochen wird. Dementsprechend können auch die Mischschaltung 46 und/oder die Vergleichsschaltungen 38, 41 und 50 in anderer Art, als in Figur 5 bzw. in Figur 4 dargestellt, ausgebildet werden.

Einige wesentliche Vorteile des hier anhand eines Hörgerätes beschriebenen Prinzips einer Begrenzerschaltung (Peak-Clipping-Schaltung) sind darin zu sehen, daß nach dem erfindungsgemäßen Verfahren bzw. bei der erfindungsgemäßen Schaltung immer nur die tatsächlich benötigte Leistung aus einer Hörgerätebatterie entnommen wird. Es entstehen z.B. keine Verluste an einem sonst üblichen Widerstand zur Strombegrenzung. Des weiteren geschieht die Begrenzung ohne Verstärkungsverlust. Es entsteht keine spektrale Verbreiterung des Signals vor dem Pulsweitenmodulator, wie sie bei einer Vorstufen-PC auftritt. Dementsprechend entstehen auch nur geringe Rückfaltungsprodukte (geringe Verzerrungen) im Basisband (Ausgangssignal). Die entstehenden Begrenzersignale 20 und 33 können zur Anzeige benutzt werden, daß die PC wirksam ist. Der Begrenzungspegel kann elektronisch, z.B. über digitale Programmierung, einstellbar ausgebildet werden. Die gesamte Schaltungsanordung ist voll in ein Hörgerät integrierbar, d.h. es werden keine externen Bauelemente benötigt.

## Patentansprüche

1. Verfahren zum Begrenzen eines Ausgangssignales, das aus einem pulsdauermodulierten Signal über ein demodulierend wirkendes Mittel (37) entnehmbar ist, mit folgenden Verfahrensschritten:
- aus einem dreieckförmigen Abtastsignal (2) und aus einem Basissignal (1) wird ein Summensignal (3) gebildet, das mit einem Basispotential (4) auf Ubereinstimmung (5, 6, 7) verglichen wird,
- aus jeder Übereinstimmung (5, 6, 7) wird eine Impulsflanke (8, 9, 10) eines Steuersignales (11) erzeugt, das zwischen zwei Pegeln (12, 13) wechselt,
- das Summensignal (3) wird Zusätzlich wenigstens mit einem ersten Schwellenpotential (15) auf Ubereinstimmung (16, 17) verglichen,
- aus jeder Übereinstimmung (16, 17) mit dem ersten Schwellenpotential (15) wird eine Impulsflanke (18, 19) eines ersten Begrenzersignales (20) erzeugt, das zwischen zwei Pegeln (21, 22) wechselt,
- das Steuersignal (11) und das erste Begrenzersignal (20) werden miteinander zu einem zweiten Steuersignal (11′) gemischt, derart, daß während der Dauer (23) eines Impulses im ersten Begrenzersignal (20) der jeweils vorhandene Pegel (12, 13) des zweiten Steuersignals (11′) wechselt.

2. Verfahren nach Anspruch 1, wobei das Summensignal (3) mit einem gegenüber dem ersten Schwellenpotential (15) gegenpolig wirkenden zweiten Schwellenpotential (27) auf Ubereinstimmung (28, 29) verglichen wird, wobei aus jeder Ubereinstimmung (28, 29) mit dem zweiten Schwellenpotential (27) eine Impulsflanke (30, 31) eines zweiten Begrenzersignales (33) erzeugt wird, das zwischen zwei Pegeln (34, 35) wechselt, und wobei das Steuersignal (11) und das zweite Begrenzersignal (33) miteinander gemischt werden, derart, daß während der Dauer (32) eines Impulses im zweiten Begrenzersignal (33) der jeweils vorhandene Pegel (12, 13) des zweiten Steuersignales (11′) wechselt.

3. Verfahren nach Anspruch 1 oder 2, wobei das Verfahren in einem Hörgerät (55) verwendet wird, derart, daß das dreieckförmige Abtastsignal (2) aus einem in dem Hörgerät (55) erzeugten Ulraschallsignal gebildet wird und wobei als Basissignal (1) ein von dem Hörgerät aufgenommenes Hörschallsignal verwendet wird.

4. Verfahren nach Anspruch 3, wobei mit dem zweiten Steuersignal (11′) eine im Schaltbetrieb arbeitende Endstufe (52) des Hörgerätes (55) gesteuert wird.

5. Verfahren nach Anspruch 3, wobei der Hörer (60) des Hörgerätes (55) als demodulierend wirkendes Mittel (37) und das vom Hörer (60) abgegebene Hörschallsignal als begrenzendes Ausgangssignal (1′) verwendet wird.

6. Schaltungsanordnung, insbesondere zur Durchführung des Verfahrens nach einem der Ansprüche 1 bis 5, umfassend ein demodulierend wirkendes Mittel (37) zur Abgabe eines begrenzten Ausgangssignales (1′) und eine erste Vergleichsstufe (38), die eingangsseitig mit einem Dreieckspannungsgenerator (39) und mit einem das Basissignal (1) abgebenden Bauteil (40, 40′) zur Erzeugung des Steuersignales (11) verbunden ist, wobei eine zweite Vergleichsstufe (41) vorgesehen ist, die eingangsseitig mit dem Dreieckspannungsgenerator (39) und mit dem das Basissignal (1) abgebenden Bauteil (40, 40′) verbunden ist, wobei ein Eingang (42) der ersten Vergleichsstufe (38) mit dem Basispotential (4) und ein Eingang (44) der zweiten Vergleichsstufe (41) mit dem ersten Schwellenpotential (15) verbunden ist und wobei beide Vergleichsstufen (38, 41) ausgangsseitig über eine Mischschaltung (46) mit dem demodulierend wirkenden Mittel (37) verbunden sind.

7. Schaltungsanordnung nach Anspruch 6, wobei eine dritte Vergleichsstufe (50) vorgesehen ist, die eingangsseitig mit dem Dreieckspannungsgenerator (39) und mit dem das Basissignal (1) abgebenden Bauteil (40) verbunden ist, wobei ein Eingang (51) der dritten Vergleichsstufe (50) mit dem gegenüber dem ersten Schwellenpotential (15) gegenpolig wirkenden zweiten Schwellenpotential (27) verbunden ist und wobei die dritte Vergleichsstufe (50) ausgangsseitig über die Mischschaltung (46) mit dem demodulierend wirkenden Mittel (37) verbunden ist.

8. Schaltungsanordnung nach Anspruch 7, wobei die Mischschaltung (46) mehrstufig ausgebildet ist, derart, daß in einer ersten Mischstufe (53) die Ausgangssignale (11, 20) der ersten und zweiten Vergleichsstufe (38, 41) und in einer zweiten Mischstufe (54) die Ausgangssignale (11, 20, 33) der ersten Mischstufe (53) sowie der dritten Vergleichsstufe (50) gemischt werden.

9. Schaltungsanordnung nach Anspruch 8, wobei die erste Mischstufe (53) als EXOR-Schaltung und die zweite Mischstufe (54) als ODER-Schaltung ausgebildet ist.

10. Schaltungsanordnung nach einem der Ansprüche 6 bis 8, wobei die Vergleichsstufen (38, 41, 50) als Komparatoren ausgebildet sind.

## Claims

1. Method for limiting an output signal which can be removed from a pulse-duration-modulated signal by way of means (37) acting in a demodulating manner, having the following procedural steps:
- a summation signal (3) is formed from a triangular sample signal (2) and from a base signal (1), which summation signal is compared with a base potential (4) for correspondence (5, 6, 7),
- from each correspondence (5, 6, 7) a pulse edge (8, 9, 10) of a control signal (11) is generated, which alternates between two levels (12, 13),
- the summation signal (3) is additionally compared at least with a first threshold potential (15) for correspondence (16, 17),
- from each correspondence (16, 17) with the first threshold potential (15) a pulse edge (18, 19) of a first limiter signal (20) is generated, which alternates between two levels (21, 22),
- the control signal (11) and the first limiter signal (20) are mixed together to form a second control signal (11′) in such a way that for the duration (23) of a pulse in the first limiter signal (20) the respectively existing level (12, 13) of the second control signal (11′) changes.

2. Method according to claim 1, whereby the summation signal (3) is compared for correspondence (28, 29) with a second threshold potential (27) acting with opposite poles relative to the first threshold potential (15), whereby from each correspondence (28, 29) with the second threshold potential (27) a pulse edge (30, 31) of a second limiter signal (33) is generated, which alternates between two levels (34, 35), and whereby the control signal (11) and the second limiter signal (33) are mixed together in such a way that for the duration (32) of a pulse in the second limiter signal (33) the respectively existing level (12, 13) of the second control signal (11′) changes.

3. Method according to claim 1 or 2, whereby the method is used in a hearing aid (55) in such a way that the triangular sample signal (2) is formed from an ultrasonic signal generated in the hearing aid (55) and whereby an audible sound signal picked up by the hearing aid is used as base signal (1).

4. Method according to claim 3, whereby an output stage (52) of the hearing aid (55) operating in switching operation is controlled by the second control signal (11′).

5. Method according to claim 3, whereby the earphone (60) of the hearing aid (55) is used as means (37) acting in a demodulating manner and the audible sound signal transmitted by the earphone (60) is used as limiting output signal (1′).

6. Circuit arrangement, in particular for carrying out the method according to one of claims 1 to 5, comprising means (37) acting in a demodulating manner for the transmission of a limited output signal (1′) and a first comparison stage (38) which is connected on the input side to a delta-voltage generator (39) and to a component (40, 40′) transmitting the base signal (1) for generating the control signal (11), whereby a second comparison stage (41) is provided, which is connected on the input side to the delta-voltage generator (39) and to the component (40, 40′) transmitting the base signal (1), whereby an input (42) of the first comparison stage (38) is connected to the base potential (4) and an input (44) of the second comparison stage (41) is connected to the first threshold potential (15) and whereby both comparison stages (38, 41) are connected on the output side by way of a hybrid circuit (46) to the means (37) acting in a demodulating manner.

7. Circuit arrangement according to claim 6, whereby a third comparison stage (50) is provided, which is connected on the input side to the delta-voltage generator (39) and to the component (40) transmitting the base signal (1), whereby an input (51) of the third comparison stage (50) is connected to the second threshold potential (27) acting with opposite poles relative to the first threshold potential (15) and whereby the third comparison stage (50) is connected on the output side by way of the hybrid circuit (46) to the means (37) acting in a demodulating manner.

8. Circuit arrangement according to claim 7, whereby the hybrid circuit (46) is constructed to be multi-stage in such a way that the output signals (11, 20) of the first and second comparison stage (38, 41) are mixed in a first mixing stage (53) and the output signals (11, 20, 33) of the first mixing stage (53) and of the third comparison stage (50) are mixed in a second mixing stage (54).

9. Circuit arrangement according to claim 8, whereby the first mixing stage (53) is constructed as an EX.OR circuit and the second mixing stage (54) is constructed as an OR circuit.

10. Circuit arrangement according to one of claims 6 to 8, whereby the comparison stages (38, 41, 50) are constructed as comparators.

## Revendications

1. Procédé pour limiter un signal de sortie, qui peut être tiré d'un signal modulé selon une modulation d'impulsions en durée par l'intermédiaire d'un moyen (37) ayant une action de démodulation, comprenant les étapes opératoires suivantes :
- à partir d'un signal d'échantillonnage de forme triangulaire (2) et à partir d'un signal de base (1) est formé un signal somme (3), qui est comparé à un potentiel de base (4) pour déterminer s'il y a coïncidence (5, 7),
- à partir de chaque coïncidence (5,6,7) est produit un flanc d'impulsion (8,9,10) d'un signal de commande (11), qui alterne entre deux niveaux (12,13),
- le signal somme (3) est en outre comparé au moins à un premier potentiel de seuil (15), pour déterminer s'il y a coïncidence (16,17),
- à partir de chaque coïncidence (16,17) avec un premier potentiel de seuil (15) est produit un flanc d'impulsion (18,19) d'un premier signal de limitation (20), qui alterne entre deux niveaux (21,22),
- le signal de commande (11) et le premier signal de limitation (20) sont mélangés entre eux pour former un second signal de commande (11′) de telle sorte que le niveau présent (12,13) du second signal de commande (11′) change pendant la durée (23) d'une impulsion dans le premier signal de limitation (20).

2. Procédé suivant la revendication 1, selon lequel le signal somme (3) est comparé à un second potentiel de seuil (27), qui agit avec une polarité opposée à celui du premier potentiel de seuil (15), pour déterminer s'il y a coïncidence (28,29), et selon lequel à partir de chaque coïncidence (28,29) avec le second potentiel de seuil (27) est produit un flanc d'impulsion (30,31) d'un second signal de limitation (33), qui alterne entre deux niveaux (34,35), et selon lequel le signal de commande (11) et le second signal de limitation (33) sont mélangés de telle sorte que le niveau présent (12,13) du second signal de commande (11′) change pendant la durée (32) d'une impulsion dans le second signal de limitation (33).

3. Procédé suivant la revendication 1 ou 2, utilisé dans un appareil de correction auditive (55) de telle sorte que le signal d'échantillonnage de forme triangulaire (2) est formé à partir d'un signal ultrasonore produit dans l'appareil de correction auditive (55), et selon lequel on utilise, comme signal de base (1), un signal acoustique reçu par l'appareil de correction auditive.

4. Procédé suivant la revendication 3, selon lequel l'étage final (52), qui opère en commutation, de l'appareil de correction auditive (55), est commandé par le second signal de commande (11′).

5. Procédé suivant la revendication 3, selon lequel l'écouteur (60) de l'appareil de correction auditive (55) est utilisé en tant que moyen (37) ayant une action de démodulation et que le signal acoustique délivré par l'écouteur (60) est utilisé en tant que signal de sortie (1′) réalisant une limitation.

6. Montage, notamment pour la mise en oeuvre du procédé suivant l'une des revendications 1 à 5, comprenant un moyen (37) ayant une action de démodulation et servant à délivrer un signal de sortie (1′) réalisant une limitation, et un premier étage comparateur (38), qui est relié, côté entrée, à un générateur de tension triangulaire (39) et à un composant (40,40′), qui délivre le signal de base (1) et sert à produire le signal de commande (11), et dans lequel il est prévu un second étage comparateur (41), qui est relié côté entrée au générateur de tension triangulaire (39) et au composant (40, 40′), qui délivre le signal de base (1), une entrée (42) du premier étage comparateur (38) est reliée au potentiel de base (4), et une entrée (44) du second étage comparateur (41) est reliée au premier potentiel de seuil (15), et les deux étages comparateurs (38,41) sont reliés, côté sortie, par l'intermédiaire d'un circuit mélangeur (46), au moyen (37) ayant une action de démodulation.

7. Montage suivant la revendication 6, dans lequel il est prévu un troisième étage comparateur (50) qui est relié, côté entrée, au générateur de tension triangulaire (39) et au composant (40) délivrant le signal de base (1), une entrée (51) du troisième étage comparateur (50) est reliée au second potentiel de seuil (27) qui agit avec un signe opposé par rapport au premier potentiel de seuil (15), et dans lequel le troisième étage comparateur (50) est relié côté sortie, par l'intermédiaire du circuit mélangeur (46), au moyen (37) ayant une action de démodulation.

8. Montage suivant la revendication 7, dans lequel le circuit mélangeur (46) est réalisé avec plusieurs étages de telle sorte que les moyens de sortie (11,20) des premier et second étages comparateurs (38,41) sont mélangés dans le premier étage mélangeur (53), et les signaux de sortie (11,20,33) du premier étage mélangeur (53) ainsi que du troisième étage mélangeur (54) sont mélangés dans un second étage mélangeur (54).

9. Montage suivant la revendication 8, dans lequel le premier étage mélangeur (53) est réalisé sous la forme d'un circuit OU-EXCLUSIF et que le second étage mélangeur (54) est réalisé sous la forme d'un circuit OU.

10. Montage suivant l'une des revendications 6 à 8, dans lequel les étages comparateurs (38,41,50) sont réalisés sous la forme de comparateurs.
